# EUROPÄISCHE PATENTANMELDUNG

(11) **EP 1 401 249 A2**
(43) Veröffentlichungstag der Anmeldung: **24.03.2004**
(21) Anmeldenummer: 03020136.2
(22) Anmeldetag: 05.09.2003
(51) Int. Cl.: H05H 1/46, H01J 37/32, H01J 27/16

(54) **Plasmaquelle**

(30) Priorität: 18.09.2002 DE 10243406
(71) Anmelder: Leybold Optics GmbH, 63775 Alzenau (DE)
(72) Erfinder: Beckmann, Rudolf, 64546 Hammersbach (DE); Fuhr, Markus, 65817 Eppstein (DE); Zültzke, Walter, 63477 Maintal (DE); Weinrich, Werner, 63505 Langenselbold (DE)
(74) Vertreter: Schickedanz, Willi, Dr. Dipl.-Ing.

(57) **Zusammenfassung**

Die Erfindung betrifft eine Plasmaquelle, deren Plasma mittels einer elektrischen Spannung gezündet wird. Um die Zündung bei relativ niedrigen Spannungen vornehmen zu können, ist eine mit Löchern (13, 14) versehene Platte (5) unterhalb eines Plasmaraums (17) vorgesehen, die sich oberhalb einer Wand (21) einer Plasmakammer (3) befindet. Durch diese Platte (5) wird unterhalb des Plasmaraums (17) ein Zündraum (16) mit einem höheren Druck als im Plasmaraum (17) gebildet, in dem das Plasma zuerst zündet. Die Zündung setzt sich dann durch die Löcher der Platte (5) in den Plasmaraum (17) fort.

## Beschreibung

Die Erfindung betrifft eine Plasmaquelle nach dem Oberbegriff des Patentanspruchs 1.

Im Allgemeinen besteht ein Plasma aus einem Gemisch von drei Komponenten: freien Elektronen, positiven Ionen und neutralen Atomen oder Molekülen. Der Plasmazustand ist der natürliche Zustand jeder auf sehr hohe Temperatur erhitzten Materie.

Um Substrate mit bestimmten Materialien zu beschichten oder um Substrate zu ätzen oder zu reinigen, werden Plasmen verwendet, aus denen in der Regel die positiven Ionen mittels elektrischen und/oder magnetischen Feldern aus einem Plasma auf das Substrat beschleunigt werden.

Für die Erzeugung von Plasmen dienen Plasmaquellen oder -reaktoren. Diesen Plasmaquellen ist gemeinsam, dass in ihrem aus einem ursprünglich elektrisch neutralen Gas oder Gasgemisch ein Plasma mit den oben erwähnten drei Komponenten entsteht.

Es ist bereits eine Teilchenquelle bekannt, mit der positive, negative und neutrale Teilchen erzeugt und auf ein Substrat gebracht werden können (DE 38 03 355 A1). Diese bekannte Teilchenquelle weist einen Behälter auf, in dem sich ein zu ionisierendes Gas oder Gasgemisch befindet. In diesen Behälter strahlt eine elektromagnetische Welle ein, bei der es sich vorzugsweise um eine Mikrowelle handelt. Gleichzeitig ragt ein torusförmiges Magnetfeld in den Behälter, das mit Hilfe von Dauermagneten oder Elektromagneten erzeugt wird. Durch die gleichzeitige Einwirkung der Mikrowellen und des Magnetfelds auf die Elektronen entsteht eine so genannte Elektronen-Zyklotron-Resonanz, die eine intensive Ionisierung bewirkt. Mittels einer besonderen Steuergitteranordnung ist es möglich, positive, negative oder neutrale Teilchen aus dem Behälter abzuziehen.

Es ist weiterhin eine Hochfrequenz-Plasmaquelle bekannt, die ein Trägerelement aufweist, auf dem eine Magnetfeldspulenanordnung, ein Gasverteilungssystem und eine Einheit zur Extraktion eines Plasmastrahls angeordnet sind (WO 01/63981). Zwischen einer im Plasmaraum befindlichen Anregungselektrode und einem außerhalb des Plasmaraums befindlichen Hochfrequenzgenerator von 13,56 MHz ist eine Anpassungsschaltung vorgesehen, die in dem Plasmaraum angeordnet ist. Die Gaszuführung in Richtung Trägerelektrode erfolgt über eine Platte, die Gasfiihrungskanäle aufweist und die sich in einem Abstand zu zwei Vakuumstromdurchführungen befindet.

Nachteilig ist bei dieser Plasmaquelle, dass sie nur mit Druckstoß zündet, d. h. zum Zünden der Quelle muss der Druck in dem Plasmaraum von p = 0,02 Pa auf p > 1 Pa erhöht werden. Hierdurch benötigt man sehr lange, um wieder auf den ursprünglichen Prozessdruck von 0,02 Pa zu kommen. Die Zündspannung an einer Gasstrecke hängt bekanntlich vom Produkt aus Gasdruck p und Elektroden-Abstand d ab (so genannte Paschen-Kurve, vgl. Rutscher/Deutsch, Plasmatechnik, Grundlagen und Anwendungen, 1984, S. 52/53). Bei kleinen Drücken, z. B. p < 2 Pa, und typischen Elektrodenabständen, z. B. d < 100 cm, ist eine Zündspannung von mehr als 10 kV nötig, um ein Plasma zu zünden. Anders als bei z. B. einer Leuchtstoffröhre, die bei höheren Drücken arbeitet, ist die Verwendung einer Hochspannung zur Plasmazündung praktisch nicht möglich oder wenigstens wegen der extrem hohen Zündspannungen sehr aufwändig. Erhöht man dagegen den Druck des Plasmas, so kann bereits bei kleinen Zündspannungen eine Zündung erfolgen. Dies gilt, wenn auf der linken Seite der Paschen-Kurve gearbeitet wird, d. h. bei Drücken p < 1 Pa. Bei Drücken höher als ca. 0,05 Pa wird die freie Weglänge der Ionen kleiner als ca. 1 cm. Damit stoßen die Ionen häufig mit Gasmolekülen zusammen und verlieren auf dem Weg zum zu behandelnden Substrat soviel Energie, dass die gewünschte Wirkung ausbleibt, d. h. es kommen praktisch keine Ionen mehr an.

Es ist indessen auch eine Ionenquelle bekannt, die eine Hilfsausnehmung aufweist, wobei der Druck in der Hilfsausnehmung zweimal größer ist als der Druck in einer Hohlkathode (SU-Patent 1 402 185). Diese Hilfsausnehmung dient jedoch nicht zur Zündung. Entsprechendes gilt auch für andere bekannte Ionenquellen (RU 1 745 080, RU 2 030 015).

Die Zündung eines Plasmas kann auch durch den Einsatz einer so genannten Zündhilfe erleichtert werden. Als Zündhilfe dienen z. B. heiße Kathoden, radioaktive Substanzen oder klassische Zündkerzen. Diese Zündhilfen sind jedoch sehr wartungs- und/oder kostenintensiv. Allein die Spannung der Stromversorgung kann als wartungsarmes und kostengünstiges Zündmittel angesehen werden.

Es ist indessen eine Zündhilfe in Form einer Vor-Entladekammer bekannt, die einen höheren Druck aufweist als eine Haupt-Entladekammer (JP 61 124029 A). Das Plasma der Vor-Entladekammer gelangt hierbei inhomogen in die Haupt-Entladekammer.

Weiter ist eine Plasma erzeugende Vorrichtung bekannt, die einen Gas-Verteilungsraum aufweist, von dem aus Gas über eine Lochplatte in einen Plasmaraum eintritt (US 2002/0047536 A1). Der Gasverteilungsraum wird hierbei durch die Lochplatte und eine Wand des Plasmaraums gebildet, wobei Lochplatte und Wand elektrisch miteinander gekoppelt sind.

Der Erfindung liegt die Aufgabe zugrunde, eine Plasmaquelle zu schaffen, bei der eine sichere Zündung ohne wesentliche Druckerhöhung im Plasmaraum erreicht wird und wobei die Zündung über den ganzen Plasmaraum gleichmäßig erfolgt.

Diese Aufgabe wird gemäß den Merkmalen des Patentanspruchs 1 erreicht.

Die Erfindung betrifft somit eine Plasmaquelle, deren Plasma mittels einer elektrischen Spannung gezündet wird. Um die Zündung bei relativ niedrigen Spannungen vornehmen zu können, ist eine mit Löchern versehene Platte unterhalb eines Plasmaraums vorgesehen, die sich oberhalb einer Wand einer Plasmakammer befindet. Durch diese Platte wird unterhalb des Plasmaraums ein Zündraum mit einem höheren Druck als im Plasmaraum gebildet, in dem das Plasma mittels einer angelegten Spannung zuerst zündet. Die Zündung setzt sich dann durch die Löcher der Platte in den Plasmaraum fort.

Der mit der Erfindung erzielte Vorteil besteht insbesondere darin, dass auch ohne eine Druckerhöhung bzw. bei nur minimaler Druckerhöhung im Plasmaraum das Plasma durch bloßes Anlegen der Hochfrequenz-Spannung gezündet werden kann. Außerdem wird die Neigung zu Überschlägen (Arcing) erheblich herabgesetzt.

Ein Ausführungsbeispiel der Erfindung ist in den Zeichnungen dargestellt und wird im Folgenden näher beschrieben. Es zeigen:
Fig. 1 eine Plasmaquelle, die sich in einer Vakuumkammer befindet;
Fig. 2 eine Platte, die in der Plasmaquelle zum Einsatz kommen kann.

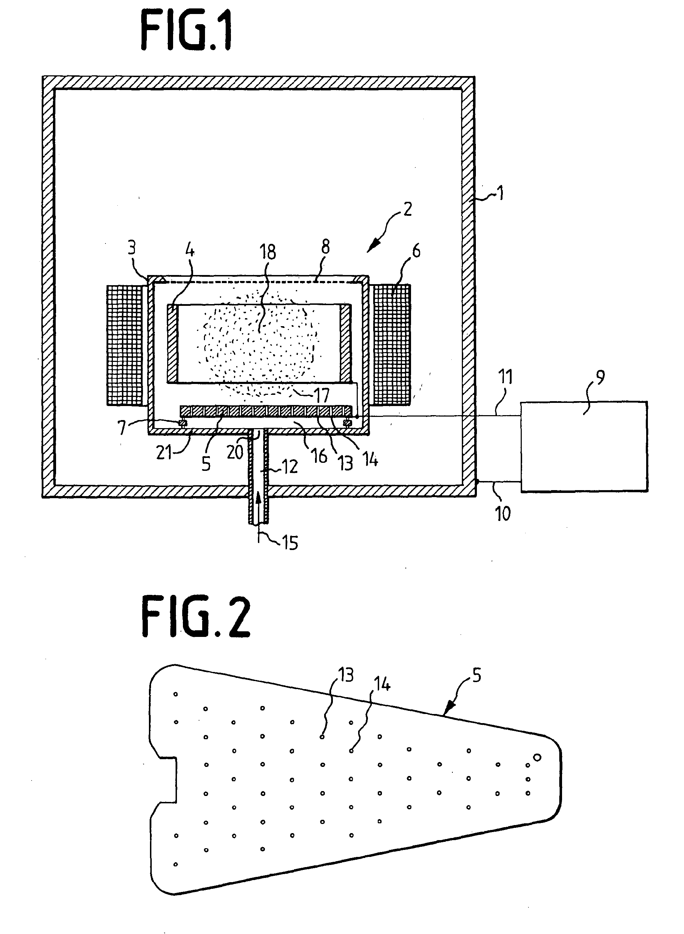

Die Fig. 1 zeigt ein Vakuumgehäuse 1, in dem Substrate beschichtet oder geätzt werden können. Diese Substrate sind in der schematischen Darstellung nicht gezeigt. Sie würden sich gegenüber einer Plasmaquelle 2 befinden, die innerhalb des Vakuumgehäuses 1 angeordnet ist. Die Plasmaquelle 2 weist ihrerseits eine Kammer 3 auf, die eine Induktionsschleife 4 sowie eine Kathodenplatte 5 umgibt. Die Induktionsschleife 4 kann aus einer Spule mit einer oder mit mehreren Windungen bestehen. Besteht sie aus nur einer Windung, so ist sie als kreisförmig gekrümmtes Blech ausgebildet, welches das Plasma umfasst. Um die Kammer 3 herum ist eine Spule 6 gelegt, mit der ein Magnetfeld erzeugt werden kann, das sich - bezogen auf die Fig. 1 - in vertikaler Richtung erstreckt. Die Kathodenplatte 5 befindet sich unterhalb der Induktionsschleife 4 und ist über eine elektrisch isolierende Dichtung 7 mit dem Boden 21 der Kammer 3 verbunden. Die Kammer 3 wird oben durch ein Steuergitter 8 begrenzt, das beispielsweise auf dem Potential des Vakuumgehäuses 1 liegt. Die Ionenenergie wird durch das Potential der Kathodenplatte 5 eingestellt. Das Steuergitter 8 ist mit einer nicht dargestellten regelbaren Spannungsquelle verbunden. Statt eines Steuergitters können auch mehrere Steuergitter hintereinander vorgesehen sein. Die vorzugsweise als Blech ausgebildete Induktionsschleife 4 steht mit ihrer Mittelachse senkrecht zu diesem Steuergitter 8.

Eine Hochfrequenz-Spannungsquelle 9 ist außerhalb des Vakuumgehäuses 1 angeordnet und mit ihrem einen Pol 10 an das Vakuumgehäuse 1 und mit ihrem anderen Pol 11 an die Kathodenplatte 5 und an die Induktionsschleife 4 angeschlossen. In der Mitte des Bodens 21 der Kammer 3 ist eine Öffnung 20 vorgesehen, an die ein Gas-Einlassrohr 12 angeschlossen ist. Das Gas-Einlassrohr 12 liegt ebenfalls an dem Potential des Pols 10.

Wesentlich für die Erfindung ist, dass die Kathodenplatte 5 mit mehreren Durchbohrungen 13, 14 versehen und ansonsten dicht, aber elektrisch isoliert in einem Abstand mit dem Boden 21 der Kammer 3 verbunden ist. Durch das Gas-Einlassrohr 12 strömt ein Gas 15 zuerst in einen Bereich 16 zwischen dem Boden 21 der Kammer 3 und der Kathodenplatte 5. Erst allmählich gelangt das Gas dann durch die Durchbohrungen 13, 14 in einen Bereich 17 oberhalb der Kathodenplatte 5, also in den eigentlichen Plasmaraum. Hierdurch entsteht in dem Bereich 16 ein höherer Druck als in dem Bereich 17. Es ist also eine Zündung im Bereich 17 möglich, ohne den Druck im Bereich 17 zu erhöhen. Hat das Plasma im Bereich 16 gezündet, springt die Zündung auch auf den Bereich 17 mit dem niedrigen Druck über, sodass sich innerhalb der Induktionsspule ionisiertes Plasma 18 ausbildet. Der Bereich 16 bildet die Zündkammer, die wesentlich kleiner ist als der Bereich 17 oberhalb der Kathodenplatte 5. Der Abstand zwischen der Kathodenplatte 5 und dem Boden 21 entspricht dem Elektrodenabstand der Paschen-Kurve. Er beträgt in der Praxis beispielsweise nur 5 mm, weil bei größeren Abständen das Volumen im Bereich 16 zu groß wird. Die Fläche des Bereichs 16, der die Zündkammer definiert, muss möglichst groß sein, damit ein maximaler Teil der Kathodenplatte 5 mit einem Gasstrom versehen wird. Eine Minimierung des Zündkammervolumens ist daher nicht durch eine kleine Fläche der Zündkammer, sondern nur durch einen kleinen Abstand zu realisieren. Bei zu großem Volumen der Zündkammer besteht die Gefahr, dass ein Großteil der Energie der Hochfrequenz-Spannungsquelle 9 in das Plasma der Zündkammer eingeführt wird und so das Plasma im Bereich 17 und damit der Ionenstrahl merklich abgeschwächt werden.

Durch die Auslegung der Kathodenplatte 5 als Gasdusche verhindert der in den Bereich 17 tretende Gasstrom offenbar auch die Belegung der Kathodenplatte mit isolierenden Schichten, sodass das einmal gezündete Plasma stabiler brennt und keine Arcings stattfinden. Wie Versuche gezeigt haben, zünden die Plasmaquellen bei einem Druckstoß von 0,05 Pa einwandfrei, während zuvor 5 Pa erforderlich waren.

Der Druck in der Zündkammer, d. h. im Bereich 16, ist so gewählt, dass man sich bei den typisch verwendeten Gasflüssen, z. B. 50 sccm, in der Nähe des Minimums der Paschen-Kurve befindet. Dieses Minimum liegt zwischen 10 Pa und 100 Pa. Der Druck lässt sich durch den Querschnitt und die Anzahl der Löcher 13, 14 in der Kathodenplatte 5 sowie durch Änderung des Gasflusses einstellen. Die leichte Druckerhöhung, die während des Zündvorgangs erforderlich ist, wird durch einen erhöhten Gasfluss erreicht.

Die Kathodenplatte 5 ist in Fig. 1 radialsymmetrisch ausgeführt, d. h. es handelt sich um eine mit ca. 52 Bohrungen versehene runde Platte. Das Substrat, welches bearbeitet werden soll, ist in der Fig. 1 nicht dargestellt. Es befindet sich dicht unterhalb der oberen Wand des Vakuumgehäuses 1. Neben der Plasmaquelle 2 und innerhalb des Vakuumgehäuses 1 kann sich ein nicht dargestellter Verdampfer befinden, in dem SiO₂ verdampft wird. Das SiO₂ kommt dann indirekt durch Streuung der verdampften Siliziummoleküle an Restgasmoleküle in der Anlage auch in die Ionenquelle. Der mit der Plasmaquelle erzeugte Ionenstrahl dient zur Verdichtung der auf dem Substrat aufgedampften Schicht.

Als Gas 15 werden vorzugsweise Sauerstoff und Argon verwendet. Sauerstoff ist für die Nachoxidation der auf dem Substrat aufgebrachten Schicht erforderlich, und Argon erleichtert das Zünden der Plasmaquelle. Bei dem Beispiel der Fig. 1 wird der Zündraum 16 zwischen dem Boden 21 der Kammer 3 und der Kathodenplatte 5 gebildet. Es ist jedoch auch möglich, den Zündraum an einer seitlichen Wand der Kammer 3 vorzusehen. Wenn man in eine Seitenwand eine Vertiefung fräst und diese durch die Induktionsschleife 4 abdichtet und viele kleine Löcher in die als Blech ausgebildete Induktionsschleife bohrt, hat man ebenfalls eine Nebenkammer geschaffen, die als Zündhilfe dienen kann. Die Induktionsschleife 4 hätte dann das gleiche Potential wie die Kathodenplatte 5.

Die Plasmaquelle 2 ist in der Fig. 1 als induktiv gekoppelt dargestellt. Es versteht sich jedoch, dass eine zusätzliche kapazitive Kopplung möglich ist, wie sie in der DE 100 08 485 A1 beschrieben ist, oder dass eine beliebige Einstrahlung von elektromagnetischen Wellen realisierbar ist.

Die Kathodenplatte 5 kann jedoch auch, wie die Fig. 2 zeigt, die Form eines Kuchenstücks haben, das mit 52 Bohrungen versehen ist.

## Patentansprüche

1. Plasmaquelle, mit
1.1 einer Kammer (3), in der Plasma erzeugt wird,
1.2 einer Platte (5) in einem Abstand von einer Wand (21 ) der Kammer (3),
1.2.1 wobei diese Platte (5) Durchbohrungen (13, 14) aufweist, durch die Gas in einen Plasmaraum (17) strömen kann und
1.2.2 wobei diese Platte (5) mit der Wand (21) der Kammer (3) einen geschlossenen Raum (16) bildet und in dieser Wand (21) ein Gaseinlass (12) vorgesehen ist;
**dadurch gekennzeichnet, dass**
1.3 die Platte (5) mit der Wand (21) über eine elektrische Isolation (7) verbunden ist und zwischen der Platte (5) und der Wand (21) eine elektrische Spannungsquelle (9) angeschlossen ist.

2. Plasmaquelle nach Anspruch 1, **dadurch gekennzeichnet, dass** die Spannungsquelle (9) eine Hochfrequenz-Spannungsquelle ist.

3. Plasmaquelle nach Anspruch 1, **dadurch gekennzeichnet, dass** in der Kammer eine Induktionsschleife (4) vorgesehen ist, die sich oberhalb der Platte (5) befindet.

4. Plasmaquelle nach Anspruch 3, **dadurch gekennzeichnet, dass** eine Vorrichtung (6) vorgesehen ist, die ein statisches Magnetfeld in dem von der Induktionsschleife (4) umfassten Raum bewirkt.

5. Plasmaquelle nach Anspruch 4, **dadurch gekennzeichnet, dass** die Vorrichtung (6) eine Spule ist.

6. Plasmaquelle nach Anspruch 1, **dadurch gekennzeichnet, dass** die elektrische Isolation (7) gleichzeitig eine Dichtung ist.

7. Plasmaquelle nach Anspruch 1, **dadurch gekennzeichnet, dass** die Platte ca. 52 äquidistant angeordnete Durchbohrungen mit einem Durchmesser von ca. 1 mm auf weist.

8. Plasmaquelle nach den Ansprüchen 2 und 3, **dadurch gekennzeichnet, dass** die Induktionsschleife (4) mit der Hochfrequenz-Spannungsquelle (9) in elektrischer Verbindung steht.

9. Plasmaquelle nach den Ansprüchen 1, 2, 3, **dadurch gekennzeichnet, dass** die Platte (5) und die Induktionsschleife (4) mit der einen Polarität der Hochfrequenz-Spannungsquelle (9) in Verbindung stehen, während die Kammer (3) mit der anderen Polarität dieser Hochfrequenz-Spannungsquelle (9) in Verbindung steht.

10. Plasmaquelle nach Anspruch 1, **dadurch gekennzeichnet, dass** die Platte (5) in der Draufsicht konisch ausgebildet ist.

11. Plasmaquelle nach Anspruch 1, **dadurch gekennzeichnet, dass** sie im Innern eines Vakuum-Gehäuses (1) angeordnet ist.

12. Plasmaquelle nach Anspruch 1, **dadurch gekennzeichnet, dass** in der Kammer (3) ein Druck p < 1 Pa herrscht.

13. Plasmaquelle nach Anspruch 1, **dadurch gekennzeichnet, dass** das erzeugte Plasma im Wesentlichen ein Ionenstrahl ist.

14. Plasmaquelle nach Anspruch 1, **dadurch gekennzeichnet, dass** die Wand der Kammer (3) der Boden ist.

15. Plasmaquelle nach Anspruch 1, **dadurch gekennzeichnet, dass** die Wand der Kammer (3) eine Seitenwand ist.

16. Plasmaquelle nach Anspruch 3, **dadurch gekennzeichnet, dass** die Induktionsschleife (4) nur eine Windung hat und aus einem gekrümmten Blech besteht.

17. Plasmaquelle nach Anspruch 15 und Anspruch 16, **dadurch gekennzeichnet, dass** die Induktionsschleife (4) die Funktion der Platte (5) übernimmt und mit Durchbohrungen versehen ist.

18. Plasmaquelle nach Anspruch 1, **dadurch gekennzeichnet, dass** die Platte (5) eine runde Scheibe ist.

19. Plasmaquelle nach Anspruch 1, **dadurch gekennzeichnet, dass** der Raum (16) zwischen der Platte (5) und der Wand (21) eine Zündkammer (16) bildet, die kleiner ist als der oberhalb der Platte (5) befindliche Plasmaraum (18).

20. Plasmaquelle nach Anspruch 19, **dadurch gekennzeichnet, dass** der Druck in der Zündkammer (16) größer ist als der Druck im Plasmaraum (18).

21. Plasmaquelle nach Anspruch 20, **dadurch gekennzeichnet, dass** der Druck in der Zündkammer (16) so gewählt ist, dass er sich bei typischen Gasflüssen in der Nähe des Minimums der Paschen-Kurve befindet.

22. Plasmaquelle nach Anspruch 21, **dadurch gekennzeichnet, dass** das Minimum zwischen 0,1 und 1 mbar liegt.

23. Plasmaquelle nach Anspruch 21, **dadurch gekennzeichnet, dass** der Druck durch den Querschnitt und die Anzahl der Löcher in der Platte (5) einstellbar ist.
